(19) Europäisches Patentamt
European Patent Office
Office européen des brevets

(11) **EP 1 570 526 B1**

(12) **FASCICULE DE BREVET EUROPEEN**

(45) Date de publication et mention
de la délivrance du brevet:
**21.12.2016 Bulletin 2016/51**

(21) Numéro de dépôt: **03789452.4**

(22) Date de dépôt: **24.11.2003**

(51) Int Cl.:
***H01L 29/66*** *(2006.01)*

(86) Numéro de dépôt international:
**PCT/EP2003/050886**

(87) Numéro de publication internationale:
**WO 2004/055901 (01.07.2004 Gazette 2004/27)**

(54) **TRANSISTOR A VANNE DE SPIN A HAUT RENDEMENT**

HOCHLEISTUNGSSPINVALVETRANSISTOR

HIGH PERFORMANCE SPIN-VALVE TRANSISTOR

(84) Etats contractants désignés:
**DE GB IT**

(30) Priorité: **13.12.2002 FR 0215845**

(43) Date de publication de la demande:
**07.09.2005 Bulletin 2005/36**

(73) Titulaire: **Thales**
**92400 Courbevoie (FR)**

(72) Inventeur: **NGUYEN VAN DAU, Frédéric**
**F-94117 Arceuil (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arceuil Cedex (FR)**

(56) Documents cités:
**US-A- 6 069 820     US-A1- 2003 214 004**

• **DIJKEN VAN S ET AL: "ROOM TEMPERATURE OPERATION OF A HIGH OUTPUT CURRENT MAGNETIC TUNNEL TRANSISTOR" APPLIED PHYSICS LETTERS, AMERICAN INSTITUTE OF PHYSICS. NEW YORK, US, vol. 80, no. 18, 6 mai 2002 (2002-05-06), pages 3364-3366, XP001123329 ISSN: 0003-6951 cité dans la demande**

• **PATENT ABSTRACTS OF JAPAN vol. 2003, no. 02, 5 février 2003 (2003-02-05) -& JP 2002 305335 A (TOSHIBA CORP), 18 octobre 2002 (2002-10-18) & US 2003/122208 A1 (SATO ET AL.) 3 juillet 2003 (2003-07-03)**

• **MONSMA D J ET AL: "PERPENDICULAR HOT ELECTRON SPIN-VALVE EFFECT IN A NEW MAGNETIC FIELD SENSOR: THE SPIN-VALVE TRANSITOR" PHYSICAL REVIEW LETTERS, NEW YORK,NY, US, vol. 74, no. 26, 26 juin 1995 (1995-06-26), pages 5260-5263, XP000675897 ISSN: 0031-9007 cité dans la demande**

• **KUMAR P S A ET AL: "The spin-valve transistor" JOURNAL OF PHYSICS D (APPLIED PHYSICS), 21 NOV. 2000, IOP PUBLISHING, UK, vol. 33, no. 22, 21 novembre 2000 (2000-11-21), pages 2911-2920, XP002252677 ISSN: 0022-3727**

• **PATENT ABSTRACTS OF JAPAN vol. 2003, no. 03, 5 mai 2003 (2003-05-05) -& JP 2002 329902 A (MIURA HIDEMI), 15 novembre 2002 (2002-11-15)**

• **SATO R ET AL: "SPIN-VALVE TRANSISTOR FORMED ON GAAS (001) SUBSTRATE" IEEE TRANSACTIONS ON MAGNETICS, IEEE INC. NEW YORK, US, vol. 38, no. 5, septembre 2002 (2002-09), pages 2863-2868, XP001131716 ISSN: 0018-9464**

**Description**

Le domaine général de l'invention est celui de la spintronique, domaine de l'électronique utilisant les propriétés magnétiques de spin des électrons. Plus précisément, le domaine de l'invention est celui des transistors à vanne de spin qui peuvent être utilisés dans de nombreux domaines de l'électronique, soit en tant que composant élémentaire (porte logique, élément de mémoire non volatil,...), soit en tant que capteur magnétorésistif dans de nombreux domaines (automobile, instrumentation, forage ou navigation), soit encore en tant que tête de lecture de support d'enregistrement magnétique haute capacité (densités d'enregistrement supérieure au téraBit/Inch$^2$).

Dans un corps ferromagnétique, la diffusion des électrons est différente selon leur spin. Cet effet est utilisé dans des dispositifs à multicouches magnétiques encore appelé vanne de spin pour créer un phénomène de magnétorésistance géante.

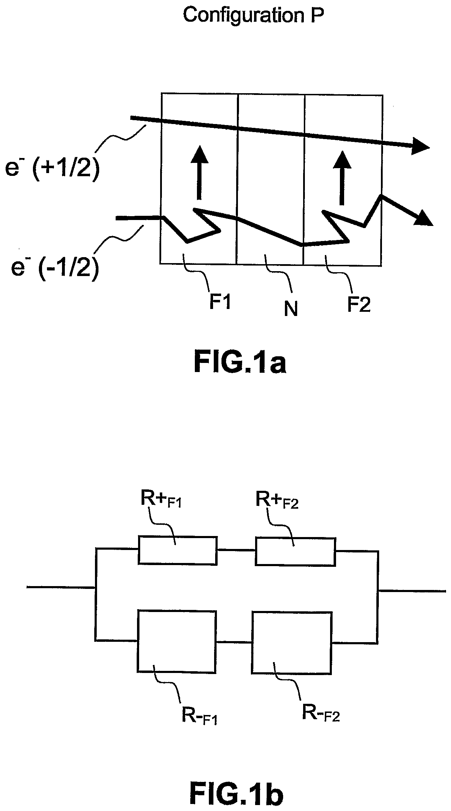

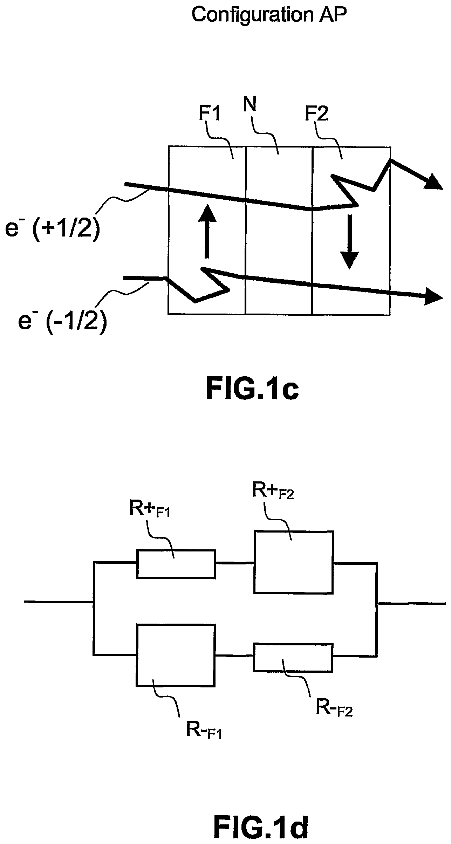

Son principe est représenté en figures 1 a et 1 c. Une vanne de spin comprend successivement trois couches de matériaux. La première couche F1 est une couche de métal ferromagnétique à aimantation imposée. La seconde couche N est une couche de métal non magnétique séparant la première couche de la troisième. La troisième couche F2 est une couche de métal ferromagnétique à aimantation variable. Le principe de fonctionnement est le suivant : Si l'on soumet la vanne de spin à un champ magnétique H, celui-ci est suffisant pour modifier le sens de l'aimantation de la seconde couche sans altérer celui de la première couche. L'aimantation imposée de la couche F2 subsiste alors après le retrait du champ magnétique H. Suivant le sens du champ magnétique appliqué, la première et la troisième couche sont donc, soit en configuration parallèle (figure 1a), les deux aimantations pointant dans le même sens (flèches verticales noires de la figure 1a), soit en configuration anti-parallèle (figure 1c), les deux aimantations pointant en sens opposé (flèches verticales noires de la figure 1c).

Dans la configuration parallèle, les électrons e- de spin +1/2 (flèche oblique supérieure de la figure 1a) traversent les couches F1 et F2 avec une diffusion faible. Les résistances $R+_{F1}$ et $R+_{F2}$ des couches F1 et F2 ont, par conséquent, une valeur r faible pour ces électrons. Les électrons e- de spin -1/2 (flèche inférieure en zigzag de la figure 1a) traversent les couches F1 et F2 avec une diffusion forte. Les résistances $R-_{F1}$ et $R-_{F2}$ des couches F1 et F2 ont, par conséquent, une valeur R importante pour ces électrons. En finale, la résistance électrique équivalente de la vanne de spin est représentée sur le schéma de la figure 1 b. Elle est équivalente à deux résistances en série de valeur r placée en parallèle avec deux résistances en série de valeur R. Si R est très grand devant r, la résistance équivalente du circuit est voisine de r.

Dans la configuration anti-parallèle, les électrons e- de spin +1/2 (flèche supérieure de la figure 1c) traversent la couche F1 avec une diffusion faible (partie en ligne droite de la flèche supérieure) et la couche F2 avec une diffusion forte (partie en zigzag de la flèche supérieure). La résistance $R+_{F1}$ de la couche F1 a, par conséquent, une valeur r faible pour ces électrons et la résistance $R+_{F2}$ de la couche F2 une valeur R importante. Les électrons e- de spin -1/2 (flèche inférieure de la figure 1c) traversent la couche F1 avec une diffusion forte (partie en zigzag de la flèche inférieure) et la couche F2 avec une diffusion faible (partie en ligne droite de la flèche inférieure). La résistance $R-_{F1}$ de la couche F1 a, par conséquent, une valeur R importante pour ces électrons et la résistance $R-_{F2}$ de la couche F2 une valeur r faible. En finale, la résistance électrique équivalente de la vanne de spin est représentée sur le schéma de la figure 1d. Elle est équivalente à deux résistances respectivement de valeur r et R mises en parallèle avec deux résistances également de valeurs r et R. Si R est très grand devant r, la résistance équivalente du circuit est maintenant voisine de R.

On modifie ainsi en fonction du champ magnétique appliqué la valeur de la résistance équivalente de la vanne de spin.

Un des domaines majeurs de recherche de la spintronique est le développement de transistors à vanne de spin. Les transistors à vanne de spin présentent des avantages importants sur les transistors classiques à semiconducteur comme, par exemple, un faible temps de commutation, de faibles énergies mises en jeu ainsi que la possibilité de programmation de portes logiques.

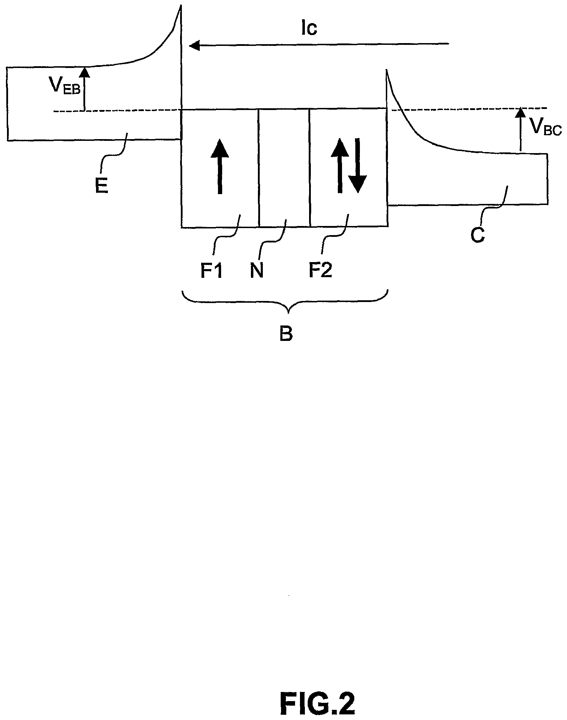

Différents concepts ont été proposés depuis 1995. Pour illustrer ces concepts représentés en figures 2, 3 et 4, on utilise une notation symbolique représentant les différentes couches du transistor. Les symboles utilisés sont les suivants :

- Couche F1 de métal ferromagnétique à aimantation permanente : rectangle comportant une flèche unique.
- Couche F2 de métal ferromagnétique à aimantation variable dépendant du champ magnétique : rectangle comportant une flèche double tête-bêche.
- Couche N de métal non magnétique : rectangle vide
- Couche de semi-conducteur présentant une barrière électronique de Schottky : rectangle surmonté par une courbe en pointe, symbolisant la barrière de Schottky.
- Couche I isolante : Losange à parois verticales.

La disposition verticale des différentes couches est représentative des différences de potentiel appliquées. Deux couches situées à des hauteurs différentes sont donc soumises à une différence de potentiel. On note $V_{EB}$ la différence de potentiel existant entre l'émetteur et la base et $V_{BC}$ la différence de potentiel existant entre la base et le collecteur.

En 1995, un premier concept a été proposé (D.J. Monsma, J.C.Lodder, T.J.A. Popma and B.Dieny - Perpendicular Hot Electron Spin-Valve Effect in a New Magnetic Field Sensor : The Spin-Valve Transistor - Physical review Letters - Vol. 74 , N° 26 - 26/06/95). Ce concept est représenté en figure 2. Le transistor proposé comprend un émetteur E en matériau semi-conducteur, une base métallique B comprenant 3 couches F1, N et F2 constituant une vanne de spin et un collecteur C également en matériau semi-conducteur. Les jonctions émetteur/base et base/collecteur sont de type Schottky comme il est indiqué sur la figure 2. La flèche indique le sens du courant collecté. Il est opposé à celui de la propagation des électrons. Des électrons sont injectés de l'émetteur vers la base à travers la base. Certains de ces électrons, dits chauds, ont une énergie suffisamment importante pour traverser la jonction Schottky émetteur/base. La relaxation énergétique de ces électrons chauds dans la base métallique dépend de leur spin. Le courant collecté $I_C$ dépend fortement de l'orientation relative des aimantations entre les couches F1 et F2. On appelle contraste de magnéto courant MC le rapport ci-dessous :

$$MC = (I_{C,P} - I_{C,AP}) / (I_{C,P} + I_{C,AP})$$

avec $I_{C,P}$ courant maximal transmis lorsque les aimantations sont en configuration parallèle et $I_{C,AP}$ courant minimal transmis lorsque les aimantations sont en configuration anti-parallèle.

De forts contrastes de courant collecteur $I_C$ ont été observés avec un tel dispositif (P.S.A. Kumar et al., Physica C350, 166 (2001)).

Cependant, les effets de relaxation des électrons dans la base sont importants, celle-ci étant composée de plusieurs interfaces successives et d'autre part, l'énergie des électrons dépend de la différence de hauteur de barrière de potentiel entre les deux jonctions Schottky émetteur/base et base/collecteur. Or, il est technologiquement très difficile de réaliser des différences de hauteurs de jonctions Schottky significatives (supérieures à 1 eV). Aussi, ce dispositif ne peut générer que des courants collecteurs de très faible intensité, de l'ordre de la dizaine de nA.

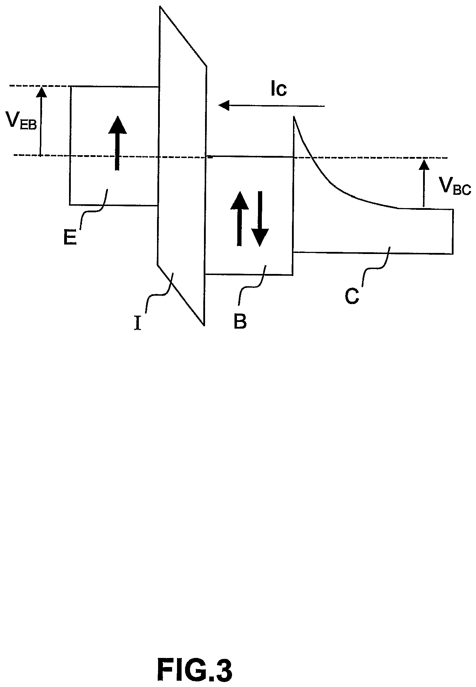

En 2001, un second concept de transistor à vanne de spin a été proposé (S.van Dijken, Xin jiang, and S.S.P. Parkin - room temperature opération of a high output current magnetic tunnel transistor - Applied Physics Letters - Vol. 80, N° 18 - 6 may 2002). Ce transistor dit MTT (pour Magnetic Tunnel Transistor) est représenté en figure 3. Il comprend un émetteur composé d'une couche ferromagnétique F1 à aimantation permanente, un isolant I, une base B composée d'une couche ferromagnétique F2 à aimantation variable et un collecteur C en matériau semi-conducteur. La jonction base/collecteur est de type Schottky comme il est indiqué sur la figure 3. Les différences de potentiel $V_{EB}$ et $V_{BC}$ nécessaires entre la base et l'émetteur et la base et le collecteur sont également représentées. Les électrons polarisés en spin sont émis depuis l'émetteur E ferromagnétique par effet tunnel dans la base ferromagnétique B. Le MTT permet de limiter les effets de relaxation des électrons dans la base qui n'est plus constituée que d'une seule couche. On obtient alors des courants $I_C$ en sortie du collecteur plus importants. Cependant, la configuration en jonction tunnel magnétique conduit à des contrastes de courant $I_C$ plus faible entre configurations parallèle et anti-parallèle des aimantations (inférieur à 70%). Ceci résulte du fait que ce dispositif n'exploite pas la dépendance en spin de la longueur caractéristique de relaxation des électrons chauds.

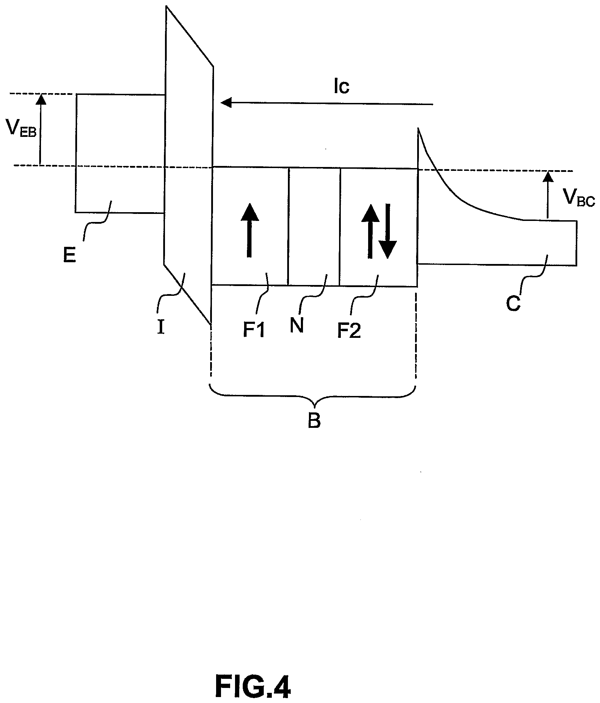

Enfin, en 2002, une variante du MTT a été proposée (S.S.P. Parkin - Intermag europe Conférence - Amsterdam - May 2002). Elle est représentée en figure 4. Elle comprend un émetteur E en matériau semi-conducteur, un isolant I, une base B qui est une vanne de spin comprenant trois couches métalliques F1, N et F2 et un collecteur en matériau semi-conducteur. La jonction base/collecteur est de type Schottky. L'émetteur émet, par effet tunnel, des électrons non polarisés en spin vers la structure en vanne de spin de la base B. Des contrastes de courant collecteur très élevés (supérieurs à 3000%) ont été observés avec cette structure. Néanmoins, la tension $V_{EB}$ susceptible d'être appliquée entre l'émetteur et la base est limitée par le phénomène de claquage dans la barrière tunnel et limite, par conséquent, l'intensité du courant émetteur $I_E$. L'intensité du courant collecteur $I_C$ qui est proportionnelle à l'intensité du courant émetteur $I_E$ reste également limitée.

On citera également la publication de Kumar S.A. et AL. intitulée « The spin-valve transistor », Journal of Physics D : Applied Physics, intitude of Physics publishing LTD, GB, Vol. 33, N° 22, 1 novembre 2000, pages 2911-2920 qui décrit un transistor à vanne de spin de ce type.

L'objet de l'invention est de fournir un nouvel agencement de transistor à vanne de spin permettant d'obtenir à la fois une forte intensité et un fort contraste du courant collecteur $I_C$, ce qui est souhaitable pour les applications de type senseurs (détecteurs de champ faible ou tête de lecture) ou comme élément de mémoire non volatil ou encore comme porte logique programmable.

Plus précisément, l'invention a pour objet un transistor à vanne de spin comportant un émetteur, une base et un collecteur, l'émetteur étant réalisé dans un matériau semi-conducteur, la base étant constituée de trois couches de métal successives, la première couche et la troisième couche ferromagnétiques, la seconde couche n'étant pas ferromagnétique, l'interface entre l'émetteur et les couches de la base constituant une diode Schottky, caractérisé en ce que le collecteur est métallique et séparé de la base par une couche isolante mince ayant une épaisseur comprise entre 1 et 4 nanomètres, ladite couche constituant une barrière à effet tunnel entre la base et ledit collecteur.

Avantageusement, la couche isolante présente une barrière de potentiel de hauteur inférieure à la barrière de potentiel de la diode Schottky existant entre l'émetteur et la base.

Avantageusement, ladite couche isolante est en oxyde de tantale ou en sulfure de zinc ou en oxyde de zirconium ou en oxyde de terre rare tel que l'yttrium.

Avantageusement, l'émetteur comporte au moins une couche de matériau semi-conducteur et le collecteur au moins une première couche de matériau métallique, la couche de matériau semi-conducteur de l'émetteur comporte au moins une seconde couche de matériau métallique permettant le raccordement de moyens de connexions électriques. Ces moyens de connexion électrique sont implantés au niveau de la première couche de matériau métallique, au niveau de la seconde couche de matériau métallique et d'une quelconque des couches de la base, lesdits moyens de connexion permettant d'appliquer au transistor des tensions et des courants extérieurs.

Enfin, la tension électrique appliquée entre l'émetteur et la base par l'intermédiaire des moyens de connexion est avantageusement supérieure à la barrière de potentiel de la couche isolante.

L'invention sera mieux comprise et d'autres avantages apparaîtront à la lecture de la description qui va suivre donnée à titre non limitatif et grâce aux figures annexées parmi lesquelles :

- Les figures 1a, 1b, 1c et 1d représentent les schémas de principe d'une vanne de spin et les schémas électriques équivalents dans les états Parallèle et Anti-Parallèle.
- La figure 2 représente le schéma symbolique d'un premier mode de réalisation d'un transistor à vanne de spin selon l'art antérieur.
- La figure 3 représente le schéma symbolique d'un transistor à vanne de spin de type MTT selon l'art antérieur selon une première variante.
- La figure 4 représente le schéma symbolique d'un transistor à vanne de spin de type MTT selon l'art antérieur selon une seconde variante.
- La figure 5 représente le schéma symbolique d'un transistor à vanne de spin selon l'invention.
- La figure 6 représente l'agencement des différentes couches dudit transistor ainsi que les connexions électriques associées du transistor selon l'invention.

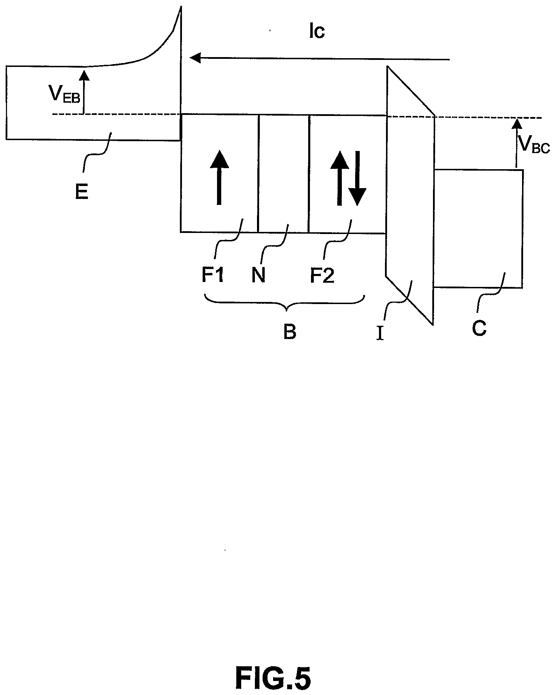

La figure 5 représente un schéma symbolique du transistor à vanne de spin selon l'invention. Il comprend un émetteur E en matériau semiconducteur, une base métallique B comprenant 3 couches F1, N et F2 constituant une vanne de spin, un matériau isolant I et un collecteur C en matériau électriquement conducteur. La jonction émetteur/base est de type Schottky comme il est indiqué sur la figure 5. La flèche indique le sens du courant collecté. Des électrons sont injectés de l'émetteur vers la base à travers la jonction Schottky émetteur/base. Les électrons passent de la base B au collecteur C à travers l'isolant I soit par effet tunnel, soit de manière balistique. Cette disposition a deux avantages majeurs sur les dispositions antérieures. L'utilisation d'une jonction émetteur/base de type Schottky permet d'utiliser des tensions $V_{EB}$ émetteur/base plus importantes qui ne sont plus limitées par le phénomène de claquage. On peut ainsi obtenir de forts courants émetteurs $I_E$ et par conséquent, de forts courants collecteurs $I_C$. La base étant constituée d'une vanne de spin, le contraste MC du courant collecteur peut également prendre des valeurs importantes.

Pour optimiser le dispositif, les matériaux doivent être choisis de façon à obtenir à la fois une hauteur de barrière Schottky élevée et une barrière tunnel de hauteur faible, inférieure à la hauteur de barrière Schottky. L'isolant peut notamment être constitué d'oxyde de tantale ou de sulfure de zinc ou en oxyde de zirconium ou en oxyde de terre rare tel que l'oxyde d'yttrium. Le matériau de l'émetteur est classiquement un matériau semi-conducteur comme le silicium ou l'arséniure de gallium. Les couches de matériaux constituant la base sont notamment, du cobalt ou un alliage de cobalt pour la couche ferromagnétique F1, du cuivre ou de l'or pour la couche neutre N, un alliage de nickel et de fer comme le permalloy (comprenant 80% de nickel) pour la couche ferromagnétique F2, enfin la couche conductrice peut être du cuivre ou de l'or.

Le courant collecteur $I_C$ est la somme de deux courants : $I_{tunnel}$, courant tunnel entre base et collecteur et $I_{balistique}$, courant balistique provenant de l'émetteur constitué des électrons ayant suffisamment d'énergie pour traverser la jonction Schottky puis la base sans relaxer. Le courant tunnel ne jouant aucun rôle dans le fonctionnement du transistor, il convient de le minimiser. Il correspond, en électronique classique, à un courant de fuite. Le moyen le plus simple est d'épaissir l'isolant I servant de barrière tunnel entre la base et le collecteur, le courant tunnel décroissant exponentiellement avec cette épaisseur.

Il est également avantageux d'utiliser une tension Emetteur/Base $V_{EB}$ supérieure à la hauteur de la barrière tunnel. Dans ce cas, une partie significative des électrons peut passer au-dessus de la barrière tunnel pour parvenir au collecteur de manière balistique. On augmente ainsi l'intensité du courant collecteur.

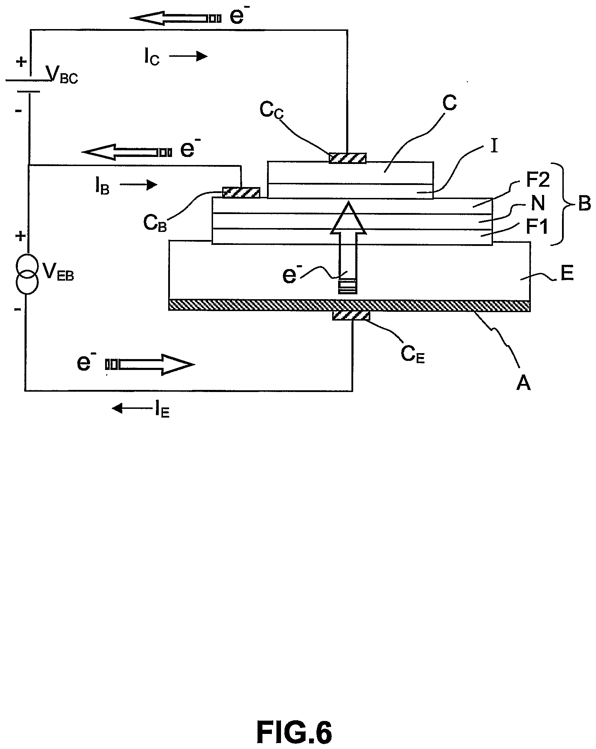

Technologiquement, le transistor spintronique selon l'invention se présente comme un empilement de couches comme il est représenté en figure 6. Cet empilement peut être réalisé par les méthodes de dépôt utilisées en micro-électronique classique. Il comprend successivement une couche métallique A, la couche de semiconducteur de l'émetteur E, les trois couches métalliques F1, N et F2 constituant la base, la couche de matériau isolant I et la couche métallique C du collecteur. Les connexions électriques de l'émetteur, de la base et du collecteur sont assurées par des moyens de connexion $C_E$, $C_B$ et $C_c$ qui peuvent être par exemple des plots métalliques. Ces moyens de connexion $C_E$, $C_B$ et $C_C$ sont situés au niveau de la couche métallique A située sous l'émetteur E, au niveau de la base et sur la couche C du collecteur. La connexion peut se faire au niveau de la base sur l'une quelconque des trois couches F1, N ou F2. Sur la figure 6, est représenté également un schéma électrique de polarisation du transistor. Un générateur de courant relié au transistor par les moyens de connexion $C_E$ et $C_B$ impose un courant $I_E$ à l'entrée de l'émetteur et une tension $V_{EB}$ entre l'émetteur et la base. Un générateur de tension relié au transistor par les moyens de connexion $C_C$ et $C_B$ impose une tension $V_{BC}$ entre la base et le collecteur. Le courant recueilli par le collecteur dépend de la configuration des aimantations imposée aux couches ferromagnétiques de la base.

**Revendications**

1. Transistor à vanne de spin comportant un émetteur (E), une base (B) et un collecteur (C), l'émetteur (E) étant réalisé dans un matériau semi-conducteur, la base étant constituée de trois couches de métal successives, la première couche (F1) et la troisième couche (F2) ferromagnétiques, la seconde couche (N) n'étant pas ferromagnétique, l'interface entre l'émetteur (E) et les couches de la base (B) constituant une diode Schottky, **caractérisé en ce que** le collecteur (C) est métallique et séparé de la base (B) par une couche isolante mince (I) ayant une épaisseur comprise entre 1 et 4 nanomètres, la dite couche constituant une barrière à effet tunnel entre la base (B) et ledit collecteur (C).

2. Transistor à vanne de spin selon la revendication 1, **caractérisé en ce que** le matériau de la couche isolante (I) présente une barrière de potentiel de hauteur inférieure à la barrière de potentiel de la diode Schottky existant entre l'émetteur (E) et la base (B).

3. Transistor à vanne de spin selon la revendication 2, **caractérisé en ce que** la couche isolante (I) est en oxyde de tantale ou en sulfure de zinc ou en oxyde de zirconium ou en oxyde de terre rare tel que l'oxyde d'yttrium.

4. Transistor à vanne de spin selon la revendication 1, **caractérisé en ce que** l'émetteur (E) comporte au moins une couche de matériau semi-conducteur et le collecteur (C) au moins une première couche de matériau métallique.

5. Transistor à vanne de spin selon la revendication 4, **caractérisé en ce que** la couche de matériau semi-conducteur de l'émetteur (E) comporte au moins une seconde couche de matériau métallique (A).

6. Transistor à vanne de spin selon la revendication 5, **caractérisé en ce que** des moyens de connexion électrique ($C_E$, $C_B$ et $C_C$) sont implantés au niveau de la première couche de matériau métallique, au niveau de la seconde couche de matériau métallique et d'une quelconque des couches (F1, N, F2) de la base, lesdits moyens de connexion permettant d'appliquer au transistor des tensions et des courants extérieurs.

7. Dispositif électronique comportant un transistor à vanne de spin selon la revendication 6 et un générateur de courant pouvant être relié au transistor par les moyens de connexion $C_E$ et $C_B$, ledit générateur imposant un courant ($I_E$) à l'entrée de l'émetteur et une tension ($V_{EB}$) entre l'émetteur et la base, **caractérisé en ce que** la tension électrique ($V_{EB}$) appliquée entre l'émetteur (E) et la base (B) par ledit générateur de courant par l'intermédiaire des moyens de connexion ($C_E$) et ($C_B$) est supérieure à la barrière de potentiel de la couche isolante (I).

**Patentansprüche**

1. Spinvalve-Transistor, der einen Emitter (E), eine Basis (B) und einen Kollektor (C) umfasst, wobei der Emitter (E) aus einem halbleitenden Material gefertigt ist, wobei die Basis von drei aufeinander folgenden Metallschichten gebildet wird, wobei die erste Schicht (F1) und die dritte Schicht (F2) ferromagnetisch sind, wobei die zweite Schicht (N) nicht ferromagnetisch ist, wobei die Grenzfläche zwischen dem Emitter (E) und den Schichten der Basis (B) eine Schottky-Diode bildet, **dadurch gekennzeichnet, dass** der Kollektor (C) metallisch und von der Basis (B) durch eine dünne Isolierschicht (I) mit einer Dicke zwischen 1 und 4 Nanometern getrennt ist, wobei die Schicht eine Tunneleffekt-Barriere zwischen der Basis (B) und dem Kollektor (C) bildet.

2. Spinvalve-Transistor nach Anspruch 1, **dadurch gekennzeichnet, dass** das Material der Isolierschicht (I) eine Potentialbarriere hat, die niedriger ist als die Potentialbarriere der Schottky-Diode zwischen dem Emitter (E) und der Basis (B).

3. Spinvalve-Transistor nach Anspruch 2, **dadurch gekennzeichnet, dass** die Isolierschicht (I) aus Tantaloxid oder Zinksulphid oder Zirkoniumoxid oder Seltenerdoxid wie Yttriumoxid gefertigt ist.

4. Spinvalve-Transistor nach Anspruch 1, **dadurch gekennzeichnet, dass** der Emitter (E) wenigstens eine Schicht aus halbleitendem Material umfasst und der Kollektor (C) wenigstens eine erste Schicht aus metallischem Material umfasst.

5. Spinvalve-Transistor nach Anspruch 4, **dadurch ge-**

**kennzeichnet, dass** die Schicht aus halbleitendem Material des Emitters (E) wenigstens eine zweite Schicht aus metallischem Material (A) umfasst.

6. Spinvalve-Transistor nach Anspruch 5, **dadurch gekennzeichnet, dass** elektrische Verbindungsmittel ($C_E$, $C_B$ und $C_C$) auf der ersten Schicht aus metallischem Material, auf der zweiten Schicht aus metallischem Material und auf einer der Schichten (F1, N, F2) der Basis installiert sind, wobei die Verbindungsmittel das Zuführen von externen Spannungen und Strömen zu dem Transistor zulassen.

7. Elektronisches Gerät, das einen Spinvalve-Transistor nach Anspruch 6 und einen Stromgenerator umfasst, der über die Verbindungsmittel $C_E$ und $C_B$ mit dem Transistor verbunden werden kann, wobei der Generator einen Strom ($I_E$) am Eingang des Emitters aufdrückt und eine Spannung ($V_{EB}$) zwischen Emitter und Basis anlegt, **dadurch gekennzeichnet, dass** die zwischen dem Emitter (E) und der Basis (B) vom Stromgenerator mittels der Verbindungsmittel ($C_E$) und ($C_B$) angelegte elektrische Spannung ($V_{EB}$) höher ist als die Potentialbarriere der Isolierschicht (I).

**Claims**

1. A spin-valve transistor comprising an emitter (E), a base (B) and a collector (C), the emitter (E) being made from a semi-conductive material, the base being formed by three successive layers of metal, the first layer (F1) and the third layer (F2) being ferromagnetic, the second layer (N) not being ferromagnetic, the interface between the emitter (E) and the layers of the base (B) forming a Schottky diode, **characterised in that** the collector (C) is metallic and is separated from the base (B) by a thin isolating layer (I) that is between 1 and 4 nanometres thick, said layer forming a tunnel effect barrier between the base (B) and said collector (C).

2. The spin-valve transistor according to claim 1, **characterised in that** the material of the isolating layer (I) has a potential barrier that is lower than the potential barrier of the Schottky diode between the emitter (E) and the base (B).

3. The spin-valve transistor according to claim 2, **characterised in that** the isolating layer (I) is made from tantalum oxide or zinc sulphide or zirconium oxide or rare earth oxide such as yttrium oxide.

4. The spin-valve transistor according to claim 1, **characterised in that** the emitter (E) comprises at least one layer of semi-conductive material and the collector (C) comprises at least one first layer of metallic material.

5. The spin-valve transistor according to claim 4, **characterised in that** the layer of semi-conductive material of the emitter (E) comprises at least one second layer of metallic material (A).

6. The spin-valve transistor according to claim 5, **characterised in that** electrical connection means ($C_E$, $C_B$ and $C_C$) are installed on the first layer of metallic material, on the second layer of metallic material and on any one of the layers (F1, N, F2) of the base, said connection means allowing external voltages and currents to be applied to the transistor.

7. An electronic device comprising a spin-valve transistor according to claim 6 and a current generator designed to be connected to the transistor via the connection means $C_E$ and $C_B$, said generator imposing a current ($I_E$) at the input of the emitter and a voltage ($V_{EB}$) between the emitter and the base, **characterised in that** the electric voltage ($V_{EB}$) applied between the emitter (E) and the base (B) by said current generator through the connection means ($C_E$) and ($C_B$) is higher than the potential barrier of the isolating layer (I).

Configuration P

**FIG.1a**

**FIG.1b**

Configuration AP

**FIG.1c**

**FIG.1d**

**FIG.2**

**FIG.3**

**FIG.4**

**FIG.5**

**FIG.6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **D.J. MONSMA ; J.C.LODDER ; T.J.A. POPMA ; B.DIENY.** Perpendicular Hot Electron Spin-Valve Effect in a New Magnetic Field Sensor : The Spin-Valve Transistor. *Physical review Letters,* 26 Juin 1995, vol. 74 (26
- **P.S.A. KUMAR et al.** *Physica,* 2001, vol. C350, 166

- **S.VAN DIJKEN ; XIN JIANG ; S.S.P. PARKIN.** room temperature opération of a high output current magnetic tunnel transistor. *Applied Physics Letters,* 06 Mai 2002, vol. 80 (18
- The spin-valve transistor. **KUMAR S.A. et al.** Journal of Physics D : Applied Physics. Physics publishing LTD, 01 Novembre 2000, vol. 33, 2911-2920